Europäisches Patentamt

European Patent Office

Office européen des brevets

(11) Numéro de publication: **0 290 315 B1**

# FASCICULE DE BREVET EUROPEEN

(45) Date de publication de fascicule du brevet: **30.09.92** (51) Int. Cl.⁵: **G01R 33/34**

(21) Numéro de dépôt: **88401014.1**

(22) Date de dépôt: **26.04.88**

(54) **Antenne de réception à découplage passif notamment pour appareil d'imagerie par résonance magnétique nucléaire.**

(30) Priorité: **07.05.87 FR 8706488**

(43) Date de publication de la demande:
**09.11.88 Bulletin 88/45**

(45) Mention de la délivrance du brevet:
**30.09.92 Bulletin 92/40**

(84) Etats contractants désignés:
**DE GB NL**

(56) Documents cités:
**EP-A- 0 142 077**          **EP-A- 0 145 915**
**EP-A- 0 164 164**          **EP-A- 0 175 129**
**EP-A- 0 218 290**          **GB-A- 2 014 796**

(73) Titulaire: **GENERAL ELECTRIC CGR S.A.**
**13, Square Max-Hymans**
**F-75015 Paris(FR)**

(72) Inventeur: **Mametsa, Henri-José**
**Cabinet Ballot-Schmit 84, Avenue Kléber**
**F-75116 Paris(FR)**
Inventeur: **Jacob, Hervé**
**Cabinet Ballot-Schmit 84, Avenue Kléber**
**F-75116 Paris(FR)**

(74) Mandataire: **Schmit, Christian Norbert Marie et al**
**Cabinet Ballot-Schmit 7, rue Le Sueur**
**F-75116 Paris(FR)**

# Description

La présente invention a pour objet une antenne de réception à découplage passif pour appareil d'imagerie par résonance magnétique nucléaire (RMN). Elle trouve plus particulièrement son application dans le domaine médical où l'imagerie par RMN s'avère précieuse comme aide au diagnostic. Elle peut trouver néanmoins son application dans d'autres domaines.

Un appareil d'imagerie par RMN comporte essentiellement des moyens pour soumettre un corps à examiner à un champ magnétique constant et instense $B_0$. Puis, soumis à cette influence, le corps reçoit d'une antenne d'émission une excitation radiofréquence pour provoquer une résonance de l'oscillation des moments magnétiques de ses particules. Dès que cette excitation radiofréquence cesse, on mesure le signal de résonance émis en retour par le corps quand les moments magnétiques des particules tendent à se réaligner avec le champ $B_0$. Pour recevoir le signal émis, on utilise quelquefois des antennes dites de surface posées sur le corps. Leur intérêt par rapport à des antennes d'émission solidaires de l'appareil est essentiellement qu'elles peuvent être placées à proximité immédiate des particules émettrices. Les antennes d'émission en sont nettement plus éloignées. L'usage de ces antennes de surface permet une amélioration sensible du rapport signal sur bruit du signal détecté.

Les antennes de surface les plus couramment utilisées (rachis, orbite, sein, genou) sont d'habitude découplées spatialement de l'antenne d'émission. L'antenne d'émission est généralement polarisée horizontalement pour minimiser les pertes par les courants de Foucault dans un patient alongé sur le dos dans l'appareil. Les antennes réceptrices de surface sont, elles, placées de manière à ce qu'elles aient une polarisation verticale du champ magnétique pour éviter, pendant l'émission, un couplage avec l'antenne d'émission. En effet, un couplage fort entre les deux antennes est très gënant car le champ réactif induit par l'antenne réceptrice tend à s'opposer à celui de l'antenne d'émission qui sert à exciter les protons. En réception, le problème est moins crucial car l'antenne de surface est beaucoup plus proche de la source de signal utile.

Le découplage spatial ainsi préconisé présente, dans certains cas, des inconvénients. Par exemple, la polarisation verticale de l'antenne de surface peut imposer que le patient doive se tourner sur le côté pendant un examen où cette antenne est plaquée contre son oreille. Il peut être nécessaire de plus qu'il se retourne de l'autre côté sur sa couche si on veut placer l'antenne de réception contre son autre oreille.

La présente invention a pour objet de remédier à ces inconvénients en proposant une antenne de réception qui comporte des moyens pour assurer le découplage des deux antennes pendant l'émission. En même temps on assure aussi sa symétrisation pour la réception du signal de résonance ainsi que la transformation de son impédance pour la transmission de ce signal. En d'autres termes, cette antenne, même placée parallèlement à une antenne d'émission, qui est une antenne corps, est insensible au champ uniforme de celle-ci. Ce résultat est obtenu sans dégradation du signal à la réception. Cette antenne de réception permet donc l'observation de n'importe quelle région du corps, entre autres l'oreille. Et le patient n'est plus obligé de se mettre sur le côté.

Une antenne de ce type est par exemple décrite dans la demande de brevet EP 0 218 290 publiée le 15 avril 1987. Cependant l'antenne décrite dans ce document n'est pas facile à fabriquer et présente peu d'aptitude à limiter l'espace de détection et a par ailleurs un gain faible.

Pour résoudre ces problèmes l'invention a pour objet une antenne selon les revendications 1 ou 4.

L'invention sera mieux comprise à la lecture de la description qui suit et à l'examen des figures qui l'accompagnent. Elles ne sont données qu'à titre indicatif et nullement limitatif de l'invention. Sur les figures les mêmes repères désignent les mêmes éléments.

Elles montrent :
- Figure 1 : un appareil d'imagerie par RMN comportant une antenne selon l'invention.
- Figures 2a et 2b : Un schéma de principe et un diagramme de fonctionnement de cette antenne représentant une variante non revendiquée de l'invention et qui n'est présentée qu'à titre illustratif ;
- Figures 3a, 3b : un exemple de réalisation d'antenne selon le principe de l'invention ;
- Figure 4 : le diagramme de fonctionnement des antennes de l'exemple précédent ;
- Figure 5 : un autre exemple de réalisation ;
- Figure 6 : un circuit de réception de l'appareil de la figure 1 comprenant un amplificateur à forte impédance d'entrée et son circuit de polarisation électrique.

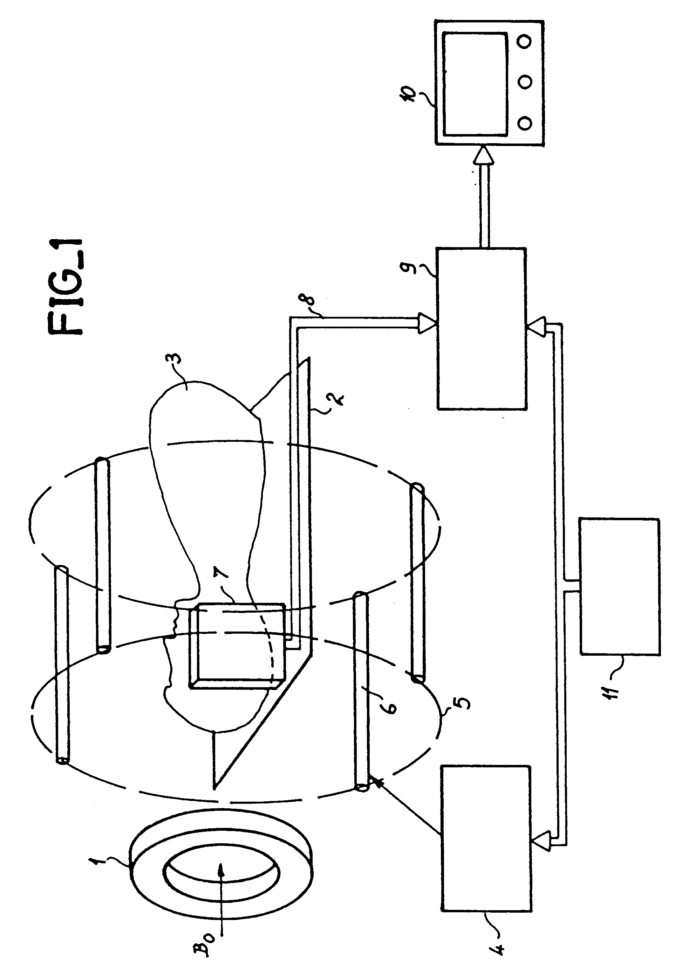

La figure 1 présente un appareil d'imagerie par RMN. Il comporte des moyens 1 pour produire un champ magnétique intense $B_0$. Un plateau 2 supporte un corps 3 soumis à l'influence de ce champ. Des moyens générateurs 4 produisent une excitation radiofréquence d'une antenne d'émission 5. Cette antenne d'émission est par exemple une antenne à quatre conducteurs rayonnants tels que le conducteur 6. En réception, le signal est prélevé par une antenne de surface 7 munie du perfectionnement de l'invention. Cette antenne de surface est symétrisée et adaptée. Le signal qu'elle détecte est acheminé par une ligne haute fréquence 8 à des circuits de réception et de traitement 9 reliés eux-mêmes à des moyens de visualisation 10 pour observer des coupes de régions examinées dans le corps 3. Un séquenceur 11 pilote les moyens générateurs 4 et de réception et de traitement 9.

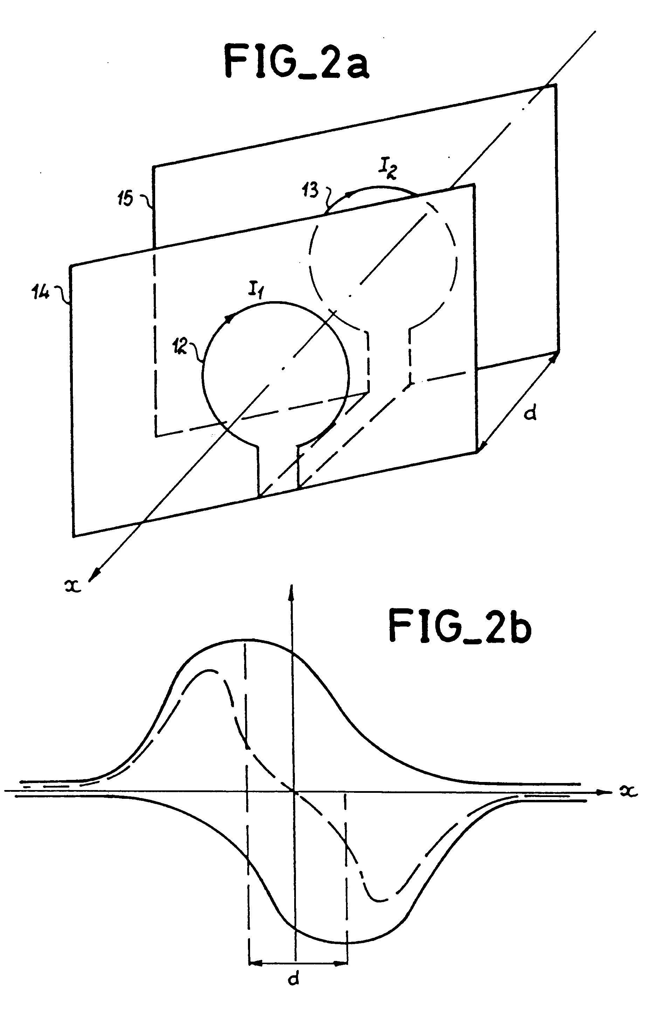

Les figures 2 montrent le schéma de principe d'une antenne selon l'invention. L'antagonisme des forces électromotrices induites dans les deux circuits transparait sous la forme des courants induits dans chacun de ces circuits quand ils sont soumis à un même champ : ces courants sont contrarotatifs. Deux boucles de même surface 12, 13 placées sur des supports 14, 15 sont en effet reliées entre elles en série de telle sorte que, dans un champ uniforme, les courants induits dans les boucles s'opposent et s'annulent (d'où le terme contrarotatif). Cependant, autant les influences exercées par un emetteur éloigné de l'antenne de l'invention sont sans effet sur celle-ci, dans la mesure où ces influences sur les deux parties de l'antenne sont de même importance, autant les influences exercées par un emetteur proche de l'antenne peuvent être différenciées. La figure 2b montre l'évolution du champ réactif opposé par chaque boucle à une induction extérieure, en fonction d'une abscisse mesurée sur un axe x perpendiculaire au plan des boucles. A grande distance de ces boucles, c'est à dire à au moins une fois leur diamètre, ces champs, fictivement opposés (à cause du raccordement électrique inverse), se neutralisent mutuellement. A proximité de l'antenne, un des deux champs prévaut selon le côté considéré. En conséquence, un émetteur (les protons excités dans le corps et retournant à leur état d'équilibre après l'excitation) placé à cet endroit proche de l'antenne influence plus une des boucles que l'autre. Un des deux courants induits l'emporte sur l'autre. Un signal peut donc être détecté. La courbe en tiret marque en quelque sorte la sensibilité de l'antenne ainsi réalisée. Plusieurs formes de circuit peuvent être envisagées sur ce principe.

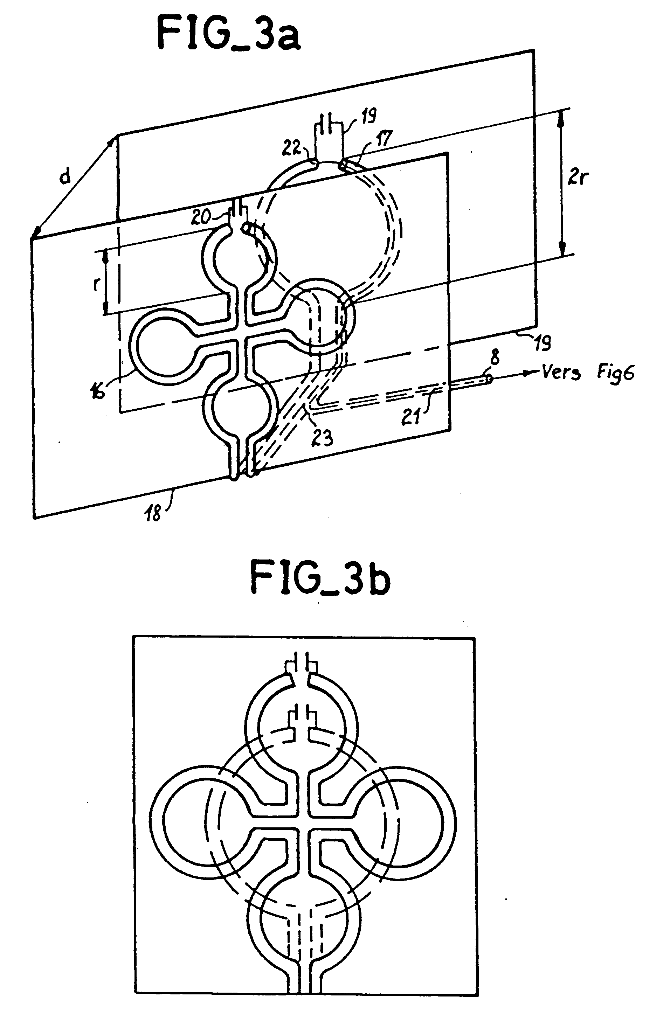

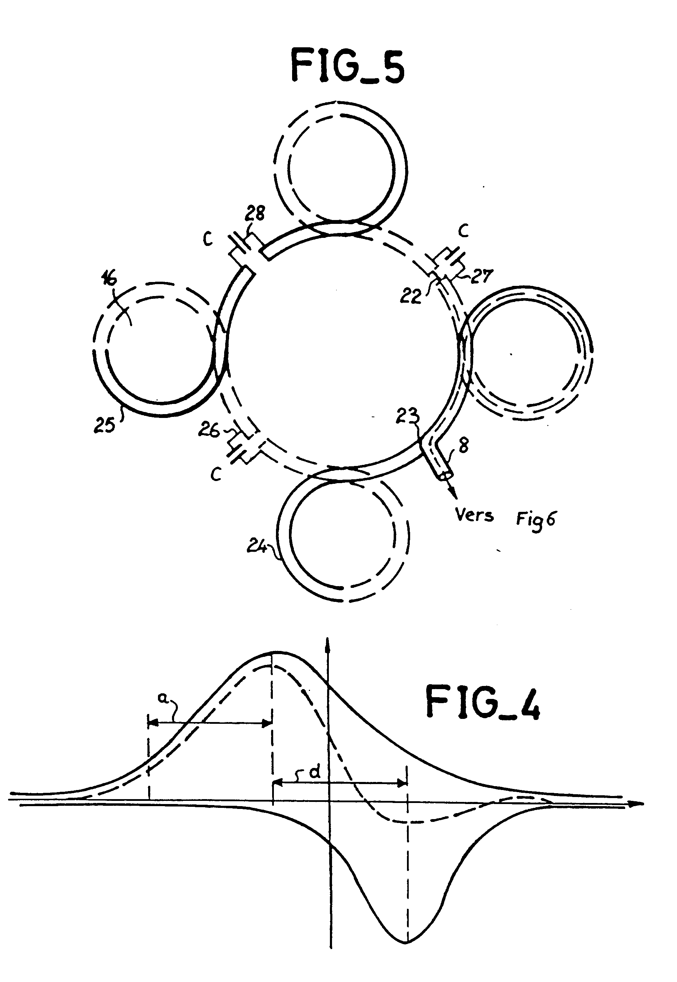

En imagerie par RMN, à la réception, il faut capter le maximum de signal utile. Or sur la figure 2, si le patient est placé à côté de la boucle 12, le courant induit $I_2$ dans la boucle 13 s'oppose à celui $I_1$ de la boucle principale 12. Pour minimiser cet effet, on pourrait augmenter la distance d séparant les deux boucles. Mais l'hypothèse sur l'uniformité du champ de l'antenne d'émission impose au contraire la plus faible distance possible. Pour trouver un compromis sur ce problème, la boucle secondaire est de préférence constituée de n petites boucles dont la surface totale est égale à la surface de la grande boucle. De cette manière les champs réactifs induits se compensent quand leur origine provient d'un émetteur éloigné (uniforme) comme l'est l'antenne d'émission. De préférence les axes de ces boucles secondaires sont régulièrement répartis et écartés de l'axe principal afin d'éloigner ces boucles du circuit principal. Les figures 3a et 3b, puis la figure 5, présentent deux exemples de réalisation où le circuit secondaire est constitué de quatre petites boucles.

Sur la figure 3a, l'ensemble des petites boucles 16 du circuit secondaire et la boucle principale 17 sont placés sur des supports 18, 19 espacés d'une distance d. Les petites boucles 16 et la boucle principlae 17 sont en série. De préférence elles sont toutes circulaires. La surface de chacune des petites boucles est sensiblement égale au quart de la surface de la grande boucle. Des capacités 19,20 servent à faire résonner respectivement la grande boucle et les boucles secondaires. La position de ces capacités dans les boucles permet d'avoir une tension moyenne nulle aux bornes de la grande boucle (et ipso facto de l'ensemble des boucles secondaires). La figure 3b montre que les axes des petites boucles sont écartés du centre de la boucle principale d'une distance sensiblement égale au rayon r de celle-ci. Un conducteur blindé 21 est relié à un point chaud 22 de la boucle principale. Le point chaud 22 est situé à mi-parcours de la boucle principale 17. Le blindage 23 du conducteur 21 participe à la boucle 17. Ce conducteur blindé permet de symétriser l'antenne et de ramener le signal vers un amplificateur à haute impédance d'entrée qui réalise aussi la transformation d'impédance. La symétrisation résulte de la connexion de l'âme 21 du conducteur blindé à la boucle 17 à l'endroit du point chaud 22 de la capacité 19. L'amplificateur est attaqué par la tension entre le conducteur 21 et le point froid 23.

La figure 4 montre le diagramme de fonctionnement des antennes des figures 3 et 5. Alors que pour un émetteur situé à grande distance de cette antenne on peut considérer que les champs réactifs induits s'opposent exactement ; à courte distance la compensation ne s'effectue pas. En outre, du fait de la disymétrie de construction des deux circuits magnétiques, l'un, le circuit principal, étend son influence d'une manière plus vaste que l'autre. Il en résulte que la sensibilité de l'antenne n'est pas trop altérée dans sa zone sensible de détection : partie a.

La figure 5 présente un autre exemple de réalisation d'antenne fonctionnant sur le principe déjà décrit. Les boucles des deux circuits y sont en série. Les courants dans les petites boucles s'opposent au courant principal quand l'ensemble est plongé dans un champ uniforme. De même que dans la figure 3a les petites boucles 16 du circuit secondaire sont distribuées régulièrement autour de l'axe de la boucle du circuit principal. La réalisation de cet exemple sur un unique circuit imprimé double face est possible. Les connexions en traits pleins 24 et 25 représentent des parties de circuit sur une première face. Les connexions en pointillés 26 et 27 représentent les parties sur une autre face. Le passage d'une face à l'autre se fait, par exemple, par des trous métallisés. Trois capacités de même valeur 26 à 28 font résonner tout le circuit. La même technique que celle décrite précédemment permet de symétriser le circuit et de réaliser l'adaptation d'impédance.

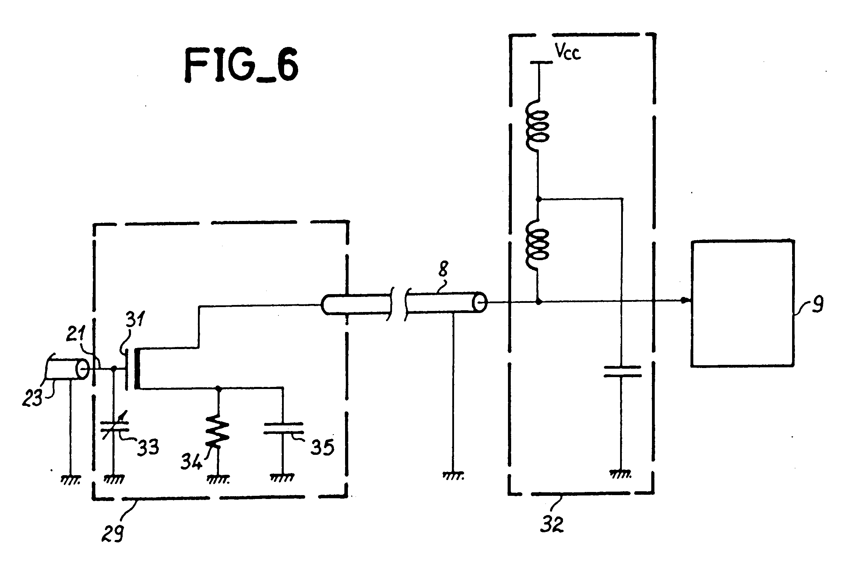

Le circuit 29 de la figure 6 effectue la transformation de l'impédance de l'antenne pour l'adapter à celle de la ligne 8. Il est placé à proximité immédiate de l'antenne, par exemple sur le même support que celle-ci. Il comporte un transistor à effet de champ 31 alimenté par un circuit 32 de polarisation découplé de la haute fréquence. Une capacité variable 33 montée en parallèle entre la masse d'une part et l'âme 21, raccordée à la grille du transitor 31, d'autre part permet de faire varier la fréquence de résonance de l'antenne dans une plage déterminée. Une résistance de polarisation 34 et une capacité de découplage 35 sont montées sur la source du transistor 31. Le signal amplifié est prélevé sur le drain du transistor 31. Il est transmis aux moyens de traitement 9, par la liaison 8.

## Revendications

1.  Antenne (7) de réception à découplage passif notamment pour un appareil (1-11) d'imagerie par résonance magnétique nucléaire, comportant deux circuits magnétiques (17;16) voisins et antagonistes pour opposer mutuellement leur force électromotrice induite quand ces forces électromotrices induites sont induites par un émetteur émettant, à l'endroit de cette antenne un champ sensiblement uniforme, le premier circuit (17) comportant une boucle magnétique, le deuxième circuit (16) comportant plusieurs boucles magnétiques dont la surface globale est sensiblement égale à la surface de la boucle du premier circuit (17), caractérisé en ce que le plan des boucles du deuxième circuit (16) est décalé du plan des boucles du premier circuit (17) et en ce que les axes, perpendiculaires en leur centre, aux boucles du deuxième circuit (16) sont régulièrement répartis dans l'espace autour de l'axe perpendiculaire à la boucle du premier circuit (17).

2.  Antenne selon la revendication 1, caractérisée en ce que les boucles du deuxième circuit (16) sont en série entre elles et avec la boucle du premier circuit (17).

3.  Antenne selon l'une quelconques des revendications 1 à 2 caractérisée en ce que les boucles sont sensiblement circulaires et en ce que les axes des boucles du deuxième circuit sont distants de l'axe de la boucle du premier circuit d'une distance égale au rayon de la boucle du premier circuit.

4.  Antenne (7) de réception à découplage passif notamment pour un appareil (1-11) d'imagerie par résonance magnétique nucléaire, comportant deux circuits magnétiques voisins (17;16) et antagonistes ($l_1$,$l_2$) pour opposer mutuellement leur force électromotrice induite quand ces forces électromotices induites sont induites par un émetteur émettant, à l'endroit de cette antenne, un champ sensiblement uniforme, le premier circuit (17) comportant une boucle magnétique, le deuxième (16) circuit comportant plusieurs boucles magnétiques dont la surface globale est sensiblement égale à la surface de la boucle du premier circuit (17), caractérisé en ce que des segments successifs de chacune des boucles du deuxième circuit (16) et des segments successifs de la boucle du premier circuit (17), sont alternativement disposés sur une face et sur l'autre face d'un support plat, de type circuit imprimé, qui porte l'antenne, chaque segment de la boucle du premier circuit (17), disposé sur l'une des faces, étant reliée en série à un segment de boucle appartenant au deuxième circuit (16) et situé sur la même face.

5.  Antenne selon la revendication 4, caractérisée en ce que les axes, perpendiculaires en leur centre, au boucles du deuxième circuit (16) sont régulièrement répartis dans l'espace autour de l'axe perpendiculaire à la boucle du premier circuit (17).

6.  Antenne selon la revendication 5 caractérisée en ce que les boucles sont sensiblement circulaires

7.  Antenne selon l'une quelconque des revendications 1 à 6 caractérisée en ce que le premier circuit comporte un tronçon (21,23) de ligne haute fréquence dont un conducteur de masse participe à la ou aux boucles de ce circuit et dont une âme, qui sert à conduire le signal de force électromotrice induite, est relié d'une part à un circuit de réception et d'autre part (22) au reste de ce premier circuit.

8.  Antenne selon la revendication 7, caractérisée en ce que le circuit de réception comporte un circuit à haute impédance d'entrée (31) raccordé au premier circuit.

9. Antenne selon l'une quelconque des revendications 1 à 8, caractérisée en ce que les circuits sont résonnants et accordés en fréquence à une fréquence de résonance de l'appareil par des capacités (26,28) distribuées dans les circuits de manière à ce qu'une tension moyenne nulle apparaisse aux bornes de ces circuits.

## Claims

1. Passive decoupling reception antenna (7) for an apparatus (1-11) for imaging by nuclear magnetic resonance, comprising two magnetic circuits (17,16) which are adjacent and antagonistic in order to oppose their respective induced elctromotive forces to each other when these induced electromotive forces are induced by an emitter which with respect to the said antenna emits a substantially uniform field, the first circuit (17) comprising a magnetic loop, the second circuit (16) comprising a number of magnetic loops of which the overall area is approximately equal to the area of the loop of the first circuit (17), characterized by the fact that the plane of the loops of the second circuit (16) is offset in relation to the plane of the loops of the first circuit (17) and that the axes perpendicular in their centre to the loops of the second circuit (16) are evenly distributed in the space around the axis perpendicular to the loop of the first circuit (17).

2. Antenna in accordance with Claim 1, characterized by the fact that the loops of the second circuit (16) are in series with one another and with the loop of the first circuit (17).

3. Antenna in accordance with either of Claims 1, 2 characterized by the fact that the loops are substantially circular and that the axes of the loops of the second circuit are distant from the axis of the loop of the first circuit by a distance equal to the radius of the loop of the first circuit.

4. Passive decoupling reception antenna (17) for an apparatus (1-11) for imaging by nuclear magnetic resonance, comprising two magnetic circuits (17, 16) which are adjacent and antagonistic in order to oppose their respective induced electromotive forces to each other when these induced electromotive forces are induced by an emitter which with respect to the said antenna emits a substantially uniform field, the first circuit (17) comprising a magnetic loop, the second circuit (16) comprising a number of magnetic loops of which the overall area is approximatey equal to the area of the loop of the first circuit (17), characterized by the fact that successive segments of each of the loops of the second circuit (16) and successive segments of the loop of the first circuit (17) are arranged in alternation on one and on the other face of a flat support of the printed circuit type, which bears the antenna, each segment of the loop of the first circuit (17), positioned on one of the faces, being connected in a series to a segment of the loop belonging to the second circuit (16) positioned on the same face.

5. Antenna in accordance with Claim 4, characterized by the fact that the axes perpendicular in their centre to the loops of the second circuit (16) are evenly distributed in the space areound the axis perpendicular to the loop of the first circuit (17).

6. Antenna in accordance with Claim 5, characterized by the fact that the loops are substantially circular.

7. Antenna in accordance with either of Claims 1 to 6, characterized by the fact that the first circuit comprises a line section 21,23) of high frequency of which a mass conductor plays a part in the loop or loops of this circuit and of which a core, which serves to conduct the induced electromotive force signal, is connected on the one hand to a receiving circuit and on the other hand (22) to the remainder of the said first circuit.

8. Antenna in accordance with Claim 7, characterized by the fact that the reception circuit comprises a high input impedance circuit (31) connected to the first circuit.

9. Antenna in accordance with any one of Claims 1 to 8, characterized by the fact that the circuits are resonant and tuned in frequency with a resonance frequency of the apparatus by capacitors (26, 28) distributed in the circuits in such a way that an average voltage of zero occurs at the terminals of these circuits.

## Patentansprüche

1. Empfangsantenne (7) mit passiver Entkoppelung, insbesondere für eine Bilderzeugungsvorrichtung (1 bis 11) mittels magnetischer Kernresonanz, mit zwei nebeneinander angeordneten, antagonistisch aufeinander wirkenden und dabei gegenseitig ihren induzierten elektromotorischen Kräften dann entgegenwirkenden magnetischen Kreisen (17 und 16), wenn diese induzierten elektromotorischen Kräfte durch einen Sender induziert werden, der am Ort der Antenne ein im wesentlichen gleichförmiges Feld aussendet, wobei der erste Kreis (17) eine und der zweite Kreis (16) mehrere magnetische Schleifen umfaßt, wovon die Gesamtfläche im wesentlichen der Fläche der Schleife des ersten Kreises (17) entspricht, dadurch gekennzeichnet, daß die Ebene der Schleifen des zweiten Kreises (16) relativ zur Ebene der Schleifen des ersten Kreises (17) versetzt ist und daß die in deren Mittelpunkt zu den Schleifen des zweiten Kreises (16) senkrecht stehenden Achsen in dem um die Achse vorhandenen Raum gleichmäßig verteilt sind, die senkrecht zur Schleife des ersten Kreises (17) steht.

2.   Antenne nach Anspruch 1, dadurch gekennzeichnet, daß die Schleifen des zweiten Kreises (16) mit sich selbst und mit der Schleife des ersten Kreises (17) in Reihe geschaltet sind.

3.   Antenne nach einem der vorhergehenden Ansprüche 1 und 2, dadurch gekennzeichnet, daß die zwei Schleifen im wesentlichen ringförmig sind und daß die Achsen der Schleifen des zweiten Kreises einen Abstand zur Achse der Schleife des ersten Kreises aufweisen, der dem Radius der Schleife des ersten Kreises entspricht.

4.   Empfangsantenne (7) mit passiver Entkoppelung, insbesondere für eine Bilderzeugungsvorrichtung (1 bis 11) mittels magnetischer Kernresonanz, mit zwei nebeneinander angeordneten, antagonistisch aufeinander wirkenden und dabei gegenseitig ihren induzierten elektromotorischen Kräften dann entgegenwirkenden magnetischen Kreisen (17 und 16), wenn diese induzierten elektromotorischen Kräfte durch einen Sender induziert werden, der am Ort der Antenne ein im wesentlichen gleichförmiges Feld aussendet, wobei der erste Kreis (17) eine und der zweite Kreis (16) mehrere magnetische Schleifen umfaßt, wovon die Gesamtfläche im wesentlichen der Fläche der Schleife des ersten Kreises (17) entspricht, dadurch gekennzeichnet, daß die nacheinanderfolgenden Segmente der jeweiligen Schleife des zweiten Kreises (16) und der folgenden Segmente der Schleife des ersten Kreises (17) abwechselnd auf beiden Oberflächen eines flachen Stützgliedes vom Typ gedruckter Schaltung angeordnet sind, die die Antenne trägt, wobei jedes Segment der Schleife des ersten Kreises (17), das auf einer der zwei Oberflächen angeordnet ist, mit einem Segment der Schleife in Reihe verbunden ist, das dem zweiten Kreis (16) zugeordnet ist und auf derselben Oberfläche liegt.

5.   Empfangsantenne nach Anspruch 4, dadurch gekennzeichnet, daß die Achsen, die in ihrem Mittelpunkt zu den Schleifen des zweiten Kreises (16) senkrecht stehenden Achsen in dem um die Achse vorhandenen Raum gleichmäßig verteilt sind, die senkrecht zur Schleife des ersten Kreises (17) steht.

6.   Empfangsantenne nach Anspruch 5, dadurch gekennzeichnet, daß die die Schleife im wesentlichen kreisförmig sind.

7.   Antenne nach einem der vorhergehenden Ansprüche 1 bis 6, dadurch gekennzeichnet, daß der erste Kreis einen Ast (21 und 23) eines Hochfrequenzleiters umfaßt, wovon ein Masseleiterelement der bzw. den Schleife(n) dieses Kreises zugeordnet ist und wovon der Kernleiter, der das induzierte Signal der elektromotorischen Kraft leitet, einerseits mit einer Empfangsschaltung und andererseits (22) mit dem übrigen Teil dieses ersten Kreises verbunden ist.

8.   Empfangsantenne nach Anspruch 7, dadurch gekennzeichnet, daß die Empfangsschaltung eine Schaltung (31) hoher Eingangsimpedanz umfaßt, die mit dem ersten Kreis verbunden ist.

9.   Antenne nach einem der vorhergehenden Ansprüche 1 bis 8, dadurch gekennzeichnet, daß die Kreise Resonanzkreise sind, die mittels Kondensatoren (26 und 28) gemäß der Resonanzfrequenz der Vorrichtung abgestimmt sind, wobei die Kondensatoren in den Kreisen so verteilt sind, daß an den Anschlüssen dieser Kreise eine Spannung mit dem Mittelwert Null anliegt.

FIG_1

EP 0 290 315 B1

# FIG_2a

# FIG_2b

# FIG_3a

# FIG_3b

# FIG_5

# FIG_4

# FIG_6

EP 0 290 315 B1